# EUROPEAN PATENT APPLICATION

(11) **EP 4 462 235 A1**
(43) Date of publication of application: **13.11.2024**
(21) Application number: 24175226.0
(22) Date of filing: 10.05.2024
(51) Int. Cl.: G06F 3/0362, G06F 3/039, H04M 1/02

(54) **MODULAR CONTROL DEVICE**

(30) Priority: 12.05.2023 TW 112117615
(71) Applicant: Cooler Master Technology Inc., Tapei City 114065 (TW)
(72) Inventor: Nguyen, Bryant Quac Bao Manh, Taipei City (TW)
(74) Representative: Grünecker Patent- und Rechtsanwälte PartG mbB

(57) **Abstract**

A modular control device including a plurality of electronic modules, module base, and at least two or more retention joints is provided. A mounting surface of the module base receives a retention surface of each plurality of electronic modules via the at least two or more retention joints. Each of the at least two or more retention joints have a module member associated with the retention surface and a base member associated with the mounting surface. The at least two or more retention joints are respectively positioned within a first portion and a second portion of the retention surface. The first portion and the second portion are equally a half-surface area of the retention surface. The at least two or more retention joints respectively define a module interface and a retention interface. Each plurality of electronic modules is configured for input of control information.

## Description

### TECHNICAL FIELD

The present disclosure is related to control devices in general and more particularly but not limited to modular control devices.

### BACKGROUND OF THE INVENTION

Editing consoles, control decks, and control panels, are control devices with shortcut buttons and controls such as knobs, dials, trackballs, encoder rings, sliders, scroll bars, trackpads and pressure pads, and touchscreen displays, for audio-, video- or image-editing, controlling live streaming, and browsing the internet. Generally, editing consoles have default layouts which can auto-detect which industry-standard application is being used to adjust the functionalities of buttons and controls of the console. For non-industry-standard applications, some editing consoles also offer customizable shortcut buttons and controls for different set-ups. For most, console layouts are fixed, thus, physical customization of the consoles are not available, which makes it inconvenient for users wanting different placement of the buttons and controls and/or different vertical or horizontal positions of the console.

### SUMMARY OF THE INVENTION

The present disclosure provides a modular control device including a plurality of electronic modules, a module base, and at least two or more retention joints. A mounting surface of the module base receives a retention surface of each plurality of electronic modules via the at least two or more retention joints. A plurality of base members of the at least two or more retention joints is associated with the mounting surface. Twenty eight plurality of base members offer users physical customization of the modular control devices as the modular control device can be vertically or horizontally positioned and buttons and controls of each plurality of electronic modules can be placed anywhere on the mounting surface via the at least two or more retention joints. Each plurality of electronic modules can have a variety of different sizes and shapes having one or more buttons, rotary knobs, sliders, scroll bars, and touchscreen displays, for mixing and matching of the modular control device, offering modularity and customizability.

In at least one embodiment, a modular control device includes a plurality of electronic modules, a module base, and at least two or more retention joints is provided. Each plurality of electronic modules has a function surface and a retention surface opposite the function surface. The retention surface defines a first portion and a second portion divided along a width thereof. Both the first portion and the second portion are equally a half-surface area of the retention surface. The module base has a mounting surface adapted to receive the retention surfaces of the plurality of electronic modules, respectively. Each of the at least two or more retention joints has a module member associated with the retention surface and a base member associated with the mounting surface. One of the at least two or more retention joints is positioned within the first portion and one other of the at least two or more retention joints is positioned within the second portion. Either the one or the one other of the at least two or more retention joints respectively define a module interface and the one other or the one of the two or more retention joints respectively define a retention interface.

In at least one embodiment, the module base receives the retention surface of each plurality of electronic modules via the at least two or more retention joints. In at least one embodiment, at least one of the module interface and the retention interface includes a snap-fit joint connection. Each plurality of electronic modules is engaged to and disengaged from the module base via the snap-fit joint connection. In at least one embodiment, each plurality of electronic modules further includes a cuboid shape and the function surface and the retention surface are both the largest surface areas of each plurality of electronic modules. In at least one embodiment, at least one side of each electronic module of the plurality of electronic modules is adjacent to one side of an other electronic module of the plurality of electronic modules, supporting engagement of each plurality of electronic modules to the module base.

In at least one embodiment, the function surface of each plurality of electronic modules is configured for input of control information. In at least one embodiment, the plurality of electronic modules further includes at least one of a button module, a rotary knob module, a slider module, a scroll bar module, and a touchscreen module, or any combination of the foregoing, each configured for providing the input of control information.

In at least one embodiment, at least one of the button module includes five buttons or fifteen buttons, the rotary knob module includes three rotary knobs, the slider module includes five sliders, the scroll bar module includes two scroll bars, and the touchscreen module includes a 1.3 inch touchscreen, a 4.3 inch touchscreen, or a 8.5 inch touchscreen, or any combination of the foregoing.

In at least one embodiment, the plurality of electronic modules further include at least one third electronic module, at least one fourth electronic module, and at least one other fifth electronic module, wherein the at least one third electronic module is a slider module configured for adjusting playback volume, the at least one fourth electronic module is a scroll bar module configured for content scrolling, and the at least one otherfifth electronic module is a touchscreen module configured for screen display and device input.

In at least one embodiment, the plurality of electronic modules further includes at least one first electronic module, at least one other first electronic module, at least one second electronic module, and at least one fifth electronic module, wherein the at least one first electronic module and the at least one other first electronic module are button modules for generating physical or virtual inputs, the at least one second electronic module is a rotary knob module for adjusting parameters, and the at least one fifth electronic module is a touchscreen module configured for screen display and device input.

In at least one embodiment, the plurality of electronic modules further include at least one first electronic module, at least one second electronic module, at least one other second electronic module, and at least one fifth electronic module, wherein the at least one first electronic module is a button module for generating physical or virtual inputs, the at least one second electronic module and the at least one other second electronic module are rotary knob modules for adjusting parameters, and the at least one fifth electronic module is a touchscreen module configured for screen display and device input.

In at least one embodiment, the module interface includes a module connector and a module port and the retention interface includes a fastener slot and a fastener prong. The module connector is defined by one module member and the module port is defined by one corresponding base member. The module connector is mounted within and electrically coupled to the module port. The fastener slot is defined by one other module member and the fastener prong is defined by one other corresponding base member. The fastener prong is mounted within the fastener slot. In at least one embodiment, the module interface includes a universal serial bus interface.

In at least one embodiment, the mounting surface includes a width and a length and the base member includes a plurality of base members. The plurality of base members is disposed in at least two or more columns parallel to the length and at least two or more rows parallel to the width. In at least one embodiment, the plurality of base members include a plurality of width edge base members, a plurality of length edge base members, and a plurality of internal base members. The plurality of width edge base members is disposed parallel to one width perimeter of the mounting surface. The plurality of length edge base members is disposed parallel to one length perimeter of the mounting surface. The plurality of internal base members is disposed between the plurality of width edge base members and an opposite width perimeter of the one width perimeter of the mounting surface and between the plurality of length edge base members and an opposite length perimeter of the mounting surface.

In at least one embodiment, each plurality of width edge base members and each plurality of length edge base members include the module port. In at least one embodiment, a distance between each plurality of width edge base members is the same and a distance between each plurality of length edge base members is the same.

In at least one embodiment, the plurality of width edge base members include four width edge base members, the plurality of length edge base members include six length edge base members, and the plurality of internal base members include eighteen internal base members. In at least one embodiment, the eighteen internal base members include six module ports and twelve fastener prongs.

The above-mentioned embodiments might be combined in any reasonable manner.

### BRIEF DESCRIPTION OF DRAWINGS

Unless specified otherwise, the accompanying drawings illustrate aspects of the innovative subject matter described herein. Referring to the drawings, wherein like reference numerals indicate similar parts throughout the several views, several examples of modular control devices incorporating aspects of the presently disclosed principles are illustrated by way of example, and not by way of limitation.
Fig. 1A is a perspective view of a modular control device according to a first embodiment of the present disclosure.
Fig. 1B is an exploded view of the modular control device of Fig. 1A.
Fig. 2 is a perspective view of another modular control device according to second embodiment of the present disclosure.
Figs. 3 is a perspective view of yet another modular control device according to third embodiment of the present disclosure.

### DETAILED DESCRIPTION

The following describes various principles related to modular control devices by way of reference to specific examples of electronic modules and module bases, including specific arrangements and examples of electronic modules, module bases, and retention joints embodying innovative concepts. More particularly, but not exclusively, such innovative principles are described in relation to selected examples of module interfaces, retention interfaces, and input of control information via buttons, rotary knobs, sliders, scroll bars, and touchscreens, and well-known functions or constructions are not described in detail for purposes of succinctness and clarity. Nonetheless, one or more of the disclosed principles can be incorporated in various other embodiments of different module interfaces, different retention interfaces, and input of control information via means different from buttons, rotary knobs, sliders, scroll bars, and touchscreens to achieve any of a variety of desired outcomes, characteristics, and/or performance criteria.

Thus, electronic modules and retention joints having attributes that are different from those specific examples discussed herein can embody one or more of the innovative principles, and can be used in applications not described herein in detail. Accordingly, embodiments of electronic modules and retention joints not described herein in detail also fall within the scope of this disclosure, as will be appreciated by those of ordinary skill in the relevant art following a review of this disclosure.

Example embodiments as disclosed herein are directed to control devices such as editing consoles, editing decks, and editing panels for audio-editing, video-editing, live streaming, and internet browsing, among others. For video-editing and audio-editing, the control devices can cut video and audio, reduce video and audio noise, combine video and audio content, modify video and audio content, add effects to video and audio, adjust audio volume, and adjust video color and brightness, among other controls. Video-editing control devices can also function as image-editing control devices. Image-editing control devices can correct image colors, crop and sharpen images, reduce image noise, and composite and retouch images, among other controls. Modular control devices are control devices that have modules, which can be added, modified, replaced, and programed to control at least one of audio-editing, video-editing, live streaming, and internet browsing, or any combination of the foregoing. Buttons can have functionalities such as copy, paste, presets, photoshop actions, and starting macros, among other functionalities. Knobs and dials can have functionalities such as adjusting tones, levels, and color grading, among other functionalities. Sliders can be used for horizontal or vertical adjustments, and real-time audio control, among other functionalities. Scroll bars can be used for content scrolling, zooming in, and zooming out, among other functionalities. Touchscreens can be used for screen display and any physical control, such as those available for user via a keyboard, among other functionalities. The electronic modules of the disclosure are configured to provide input control information to one or more applications, controlling one or more inputs of an app by an application program. Each of the plurality of electronic modules can be configured by a user.

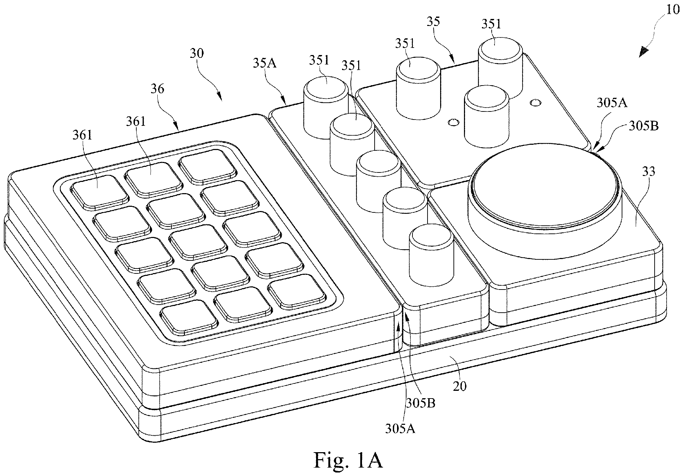

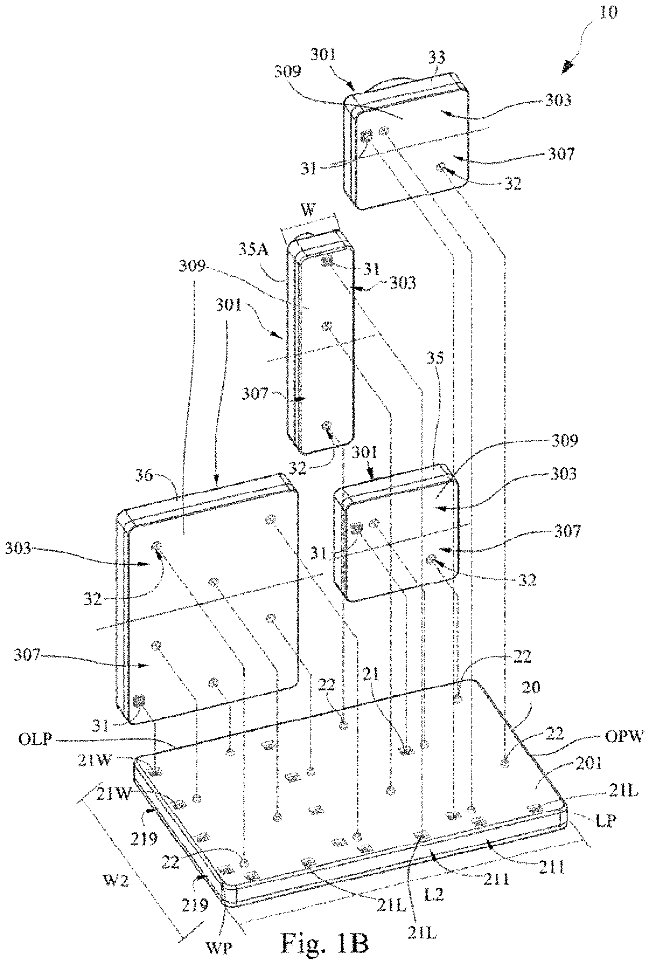

Figs. 1A and 1B show a first embodiment of a modular control device 10. The modular control device 10 includes a plurality of electronic modules 30, a module base 20, and at least two or more retention joints 31/21, 32/22 is provided. Each plurality of electronic modules 30 has a function surface 301 and a retention surface 309 opposite the function surface 301. The retention surface 309 defines a first portion 303 and a second portion 307 divided along a width W thereof. Both the first portion 303 and the second portion 307 are equally a half-surface area of the retention surface 309. The module base 20 has a mounting surface 201 adapted to respectively receive the retention surfaces 309 of the plurality of electronic modules 30. Each of the at least two or more retention joints 31/21, 32/22 has a module member associated with the retention surface 309 and a base member associated with the mounting surface 201. One of the at least two or more retention joints 31/21, 32/22 is positioned within the first portion 303 and one other of the at least two or more retention joints 31/21, 32/22 is positioned within the second portion 307. Either the one or the one other of the at least two or more retention joints 31/21, 32/22 respectively define a module interface and the one other or the one of the two or more retention joints respectively define a retention interface.

The module base 20 receives the retention surface 309 of each plurality of electronic modules 30 via the at least two or more retention joints 31/21, 32/22. In at least one embodiment, at least one of the module interface and the retention interface includes a snap-fit joint connection. Each plurality of electronic modules 30 is engaged to and disengaged from the module base 20 via the snap-fit joint connection. A snap-fit joint connection has one component with at least one protruding part, for example, a hook, stud or bead, being deflected briefly during a joining operation, to be caught in a depression (undercut) in another mating component, where the one component returns to a stress-free condition. An annular snap-fit joint is a joint between two rotationally symmetric components. In at least one embodiment, each plurality of electronic modules 30 further includes a cuboid shape and the function surface 301 and the retention surface 309 are both the largest surface areas of each plurality of electronic modules 30. At least one side 305A of each electronic module 33, 35, 35A, 36 of the plurality of electronic modules 30 is adjacent to one side 305B of an other electronic module 33, 35, 35A, 36 of the plurality of electronic modules 30, supporting engagement of each plurality of electronic modules 30 to the module base 20.

The function surface 301 of each electronic module 33, 35, 35A, 36 of the plurality of electronic modules 30 is configured for input of control information. The plurality of electronic modules 30 further includes a button module 36, a rotary knob module 35, a slider module 37, a scroll bar module 34, and a touchscreen module 33. Alternatively, the button module 36may comprise one or more buttons 361, and the rotary knob module 35 may comprise one or more rotary knobs 351. The one or more buttons 361 of the button module 36, may comprise at least one of buttons, virtual keys, and mechanical keys, or any combination of the foregoing.

In an alternative of the first embodiment, the plurality of electronic modules 30 may include at least one first electronic module 36, at least one second electronic module 35, at least one other second electronic module 35A, and at least one fifth electronic module 33, wherein the at least one first electronic module 36 is a button module 36 for generating physical or virtual inputs, the at least one second electronic module 35 and the at least one other second electronic module 35A are rotary knob modules 35, 35A for adjusting parameters, and the at least one fifth electronic module 33 is a touchscreen module 33 configured for screen display and device input.

In the first embodiment, the module interface includes a module connector 31 and a module port 21 and the retention interface includes a fastener slot 32 and a fastener prong 22. The module connector 31 is defined by one module member and the module port 21 is defined by one corresponding base member. The module connector31 is mounted within and electrically coupled to the module port 21. The fastener slot 32 is defined by one other module member and the fastener prong 22 is defined by one other corresponding base member. The fastener prong 22 is mounted within the fastener slot 32. In at least one embodiment, the fastener prong 22 is convex shaped and the fastener slot 32 is concave shaped.

The module interface includes a universal serial bus (USB) interface. The module interface exchanges data and delivers power between components in an electronics system. USB form factors may include USB Type-A, Type-B, Mini-A, Mini-B, Micro-A, Micro-B, Type-C. USB3.2 Gen 1×1 exchanges data over USB-A, USB-C, micro USB cables at speeds of at least SGbps. USB4 Version 2 exchanges data over USB Type-C cables at speeds of at least 80Gbps.

The mounting surface 201 includes a width W2 and a length L2 and the base member includes a plurality of base members. The plurality of base members is disposed in at least two or more columns 219 parallel to the length L2 and at least two or more rows 211 parallel to the width W2. The plurality of base members include a plurality of width edge base members 21W, a plurality of length edge base members 21L, and a plurality of internal base members. The plurality of width edge base members 21W is disposed parallel to one width perimeter WP of the mounting surface 201. The plurality of length edge base members 21L is disposed parallel to one length perimeter LP of the mounting surface 201. The plurality of internal base members is disposed between the plurality of width edge base members 21W and an opposite width perimeter OWP of the one width perimeter WP of the mounting surface 201 and between the plurality of length edge base members 21L and an opposite length perimeter OPL of the mounting surface 201.

Each width edge base member 21W and each length edge base member 21L includes the module port 21. All distances between two neighboring width edge base members 21W in the corresponding row 211 are equal and all distances between two neighboring length edge base members 21L in the corresponding column 219 are equal.

The plurality of width edge base members 21W include four width W edge base members 21W, the plurality of length edge base members 21L include six length edge base members 21L, and the plurality of internal base members include eighteen internal base members. The eighteen internal base members include six module ports 21 and twelve fastener prongs 22.

At least one of the button modules 36, 36A may include five buttons or fifteen buttons, the rotary knob module 35 may include three rotary knobs, the slider module 37 includes five sliders, the scroll bar module 34 includes two scroll bars, and the touchscreen module 33, 33A may include a 1.3 inch touchscreen, a 4.3 inch touchscreen, or a 8.5 inch touchscreen.

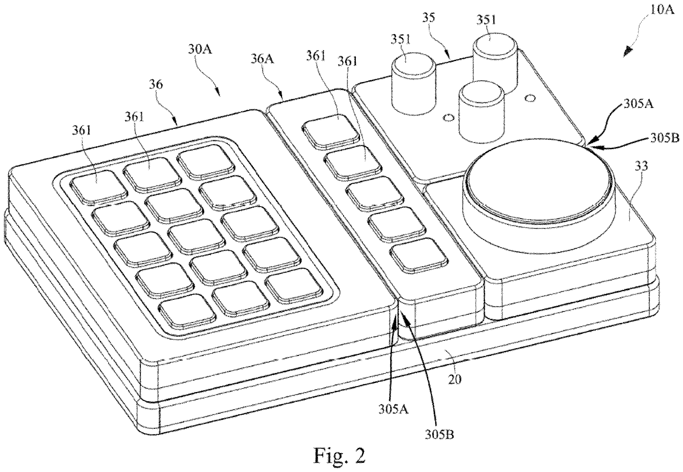

Fig. 2 shows second embodiment of another modular control device 10A. The plurality of electronic modules 30A further includes at least one first electronic module 36, at least one other first electronic module 36A, at least one second electronic module 35, and at least one fifth electronic module 33. The another modular control device 10A may be similar in some respects to the modular control device 10 of Figs. 1A and 1B, and therefore may be best understood with reference thereto where like numerals designate like components. Actually, only the distinguishing features are mentioned here. With regard to all other configurations and elements, especially those not explicitly depicted in Fig. 2 (like the configuration of the retention surface 309 and of the mounting surface 201, including the at least two or more retention joints 31/21, 32/22) it is additionally referred to the description of the modular device of Figs. 1A and 1B, because the configuration follows the same principles. The at least one first electronic module 36 and the at least one other first electronic module 36A are button modules 36, 36A for generating physical or virtual inputs, the at least one second electronic module 35 is a rotary knob module 35 for adjusting parameters, and the at least one fifth electronic module 33 is a touchscreen module 33 configured for screen display and device input.

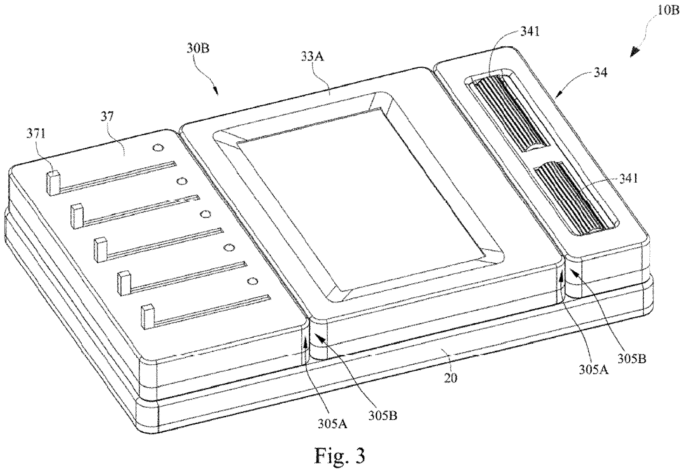

Fig. 3 shows a third embodiment of yet another modular control device 10B. The plurality of electronic modules 30B further include at least one third electronic module 37, at least one fourth electronic module 34, and at least one other fifth electronic module 33A. The yet another modular control device 10B may be similar in some respects to the modular control device 10 of Figs. 1A and 1B, and therefore may be best understood with reference thereto where like numerals designate like components. Actually, only the distinguishing features are mentioned here. With regard to all other configurations and elements, especially those not explicitly depicted in Fig. 2 (like the configuration of the retention surface 309 and of the mounting surface 201, including the at least two or more retention joints 31/21, 32/22) it is additionally referred to the description of the modular device of Figs. 1A and 1B, because the configuration follows the same principles. The at least one third electronic module 37 is a slider module 37 configured for adjusting playback volume, the at least one fourth electronic module 34 is a scroll bar module 34 configured for content scrolling, and the at least one other fifth electronic module 33A is a touchscreen module 33A configured for screen display and device input. The slider module 37 may comprise one or more sliders 371, and the scroll bar module 34 may comprises one or more scroll bars 341. The slider module 37 includes five sliders and the scroll bar module 34 includes two scroll bars.

For assembly of the modular control device 10, 10A, 10B, a preferred vertical, horizontal, or angled position of the module base 20 is chosen. Then, based on the preferred positioning, a customized combination of the plurality of electronic modules 30, 30A, 30B ('modules') having a most ideal layout of button modules 36, 36A, rotary knob modules 35, slider modules 37, scroll bar modules 34, and/or touchscreen modules 33, 33A, for audio-editing, video-editing, live streaming, and/or internet browsing, are snap-fit pressed onto the mounting surface 201 of the module base 20 for engagement and electrical coupling of the 'modules' to the module base 20. The most ideal layout of 'modules' can be placed anywhere on the mounting surface 201, whereby the at least one side 305A of each electronic module 33, 33A, 34, 35, 35A, 36, 36A of the plurality of electronic modules 30, 30A, 30B is adjacent to one side 305B of an other electronic module 33, 33A, 34, 35, 35A, 36, 36A of the plurality of electronic modules 30, 30A, 30B, supporting engagement of each plurality of electronic modules 30, 30A, 30B to the module base 20, and one of the at least two or more retention joints 31/21, 32/22 is positioned within the first portion 303 of the retention surface 309 and one other of the at least two or more retention joints 31/21, 32/22 is positioned within the second portion 307 of the retention surface 309.

For disassembly of the modular control device 10, 10A, 10B, the plurality of electronic modules 30, 30A, 30B can be disengaged from the mounting surface 201 of the module base 20 by being pulled up from the mounting surface 201. For reassembly, the above steps can be repeated.

The modular control devices 10, 10A, 10B of the present disclosure provide a variety of customizable layouts for a single control device. A user will not need to purchase a second control device for a default layout geared mainly for only one of audio-editing, video-editing, live streaming, or internet browsing, while requiring two or more different editing functionalities. For control devices offering default layouts geared for more than one of audio-editing, video-editing, live streaming, or internet browsing, generally, depending upon which editing functionalities is being performed, there is commonly other buttons, rotary knobs, sliders, scroll bars, and touchscreen displays which will not be used or not be used as much. The modular control device 10, 10A, 10B of the present disclosure maximize functionality via the twenty eight plurality of base members, as each plurality of electronic modules 30, 30A, 30B, having a variety of suitable sizes and shapes, can be easily arranged, having the most ideal layout of button modules 36, 36A, rotary knob modules 35, slider modules 37, scroll bar modules 34, and/or touchscreen modules 33, 33A for whatever layout of audio-editing, video-editing, live streaming, or internet browsing preferred by the user.

Additionally, the modular control devices 10, 10A, 10B of the present disclosure provide quick engagement and strong retention of the plurality of electronic modules 30, 30A, 30B to the mounting surface 201 of the module base 20. The snap-fit joint connection of the module interface and the retention interface is simple and easy, while also being a strong retention mechanism. The retention surface 309, being a largest surface area of each plurality of electronic modules 30, 30A, 30B, is engaged on the mounting surface 201, which is a top surface of the module base 20. The engagement of the plurality of electronic modules 30, 30A, 30B is stronger and more secure than electronic components electrically coupled via a side wall of a main control device, which is generally more prone to unwanted disengagement, loose connections, and damage. Moreover, electronic components electrically coupled via a side wall of a main control device can result in asymmetrical shapes. Thus, making it inconvenient for users with limited area for placement of the control devices, or symmetrically shaped desktops or tabletops.

Moreover, bays or fasteners on mounting surfaces 201 of control devices limit layout choices and add additional steps for engagement and disengagement of modules. In addition to the at least two or more retention joints 31/21, 32/22, at least one side 305A of each electronic module 33, 33A, 34, 35, 35A, 36, 36Aof the plurality of electronic modules 30, 30A, 30B is adjacent to one side 305B of an other electronic module 33, 33A, 34, 35, 35A, 36, 36A of the plurality of electronic modules 30, 30A, 30B. Thus, engagement of each plurality of electronic modules 30, 30A, 30B to the module base 20 is supported, further eliminating the need for bays and additional engagement and disengagement steps due to the fasteners.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the element that it introduces.

## Claims

1. A modular control device (10, 10A, 10B), comprising:
a plurality of electronic modules (30, 30A, 30B), each plurality of electronic modules (30, 30A, 30B) having a function surface (301) and a retention surface (309) opposite the function surface (301), the retention surface (309) defining a first portion (303) and a second portion (307) divided along a width of the retention surface (309), both the first portion (303) and the second portion (307) equally a half surface area of the retention surface (309),
a module base (20) having a mounting surface (201), the mounting surface (201) adapted to respectively receive the retention surfaces (309) of the plurality of electronic modules (30, 30A, 30B), and
at least two or more retention joints (31/21, 32/22), each of the at least two or more retention joints (31/21, 32/22) having a module member associated with the retention surface (309) and a base member associated with the mounting surface (201), one of the at least two or more retention joints positioned within the first portion (303) and one other of the at least two or more retention joints positioned within the second portion (307), either the one or the one other of the at least two or more retention joints (31/21, 32/22) respectively define a module interface and the one other or the one of the at least two or more retention joints (31/21, 32/22) respectively define a retention interface.

2. The modular control device (10, 10A, 10B) of claim 1, wherein the module base (20) receives the retention surface (309) of each plurality of electronic modules (30, 30A, 30B) via the at least two or more retention joints (31/21, 32/22).

3. The modular control device (10, 10A, 10B) of claim 1 or 2, wherein at least one of the module interface and the retention interface comprises a snap-fit joint connection, wherein each plurality of electronic modules (30, 30A, 30B) is engaged to and disengaged from the module base (20) via the snap-fit joint connection.

4. The modular control device (10, 10A, 10B) of one of claims 1 to 3, wherein each plurality of electronic modules (30, 30A, 30B) further comprise a cuboid shape and the function surface (301) and the retention surface (309) are both largest surface areas of each plurality of electronic modules (30, 30A, 30B).

5. The modular control device (10, 10A, 10B) of claim 4, wherein at least one side (305A) of each electronic module (33, 33A, 34, 35, 35A, 36, 36A, 37) of the plurality of electronic modules (30, 30A, 30B) is adjacent to one side (305B) of an other electronic module (33, 33A, 34, 35, 35A, 36, 36A, 37) of the plurality of electronic modules (30, 30A, 30B), supporting engagement of each plurality of electronic modules (30) to the module base (20).

6. The modular control device (10, 10A, 10B) of one of claims 1 to 5, wherein the function surface (301) of each plurality of electronic modules (30, 30A, 30B) is configured for input of control information.

7. The modular control device (10, 10A, 10B) of one of claims 1 to 6, wherein the plurality of electronic modules (30, 30A, 30B) further comprises two or more electronic modules (33, 33A, 34, 35, 35A, 36, 36A, 37), each selected from the following group of electronic modules: a button module (36, 36A), a rotary knob module (35), a slider module (37), a scroll bar module (34), and a touchscreen module (33, 33A), each configured for providing the input of control information.

8. The modular control device (10, 10A, 10B) of claim 7, wherein at least one of the button module (36A, 36) comprises five buttons or fifteen buttons, the rotary knob module (35, 35A) comprises three rotary knobs (351), the slider module (37) comprises five sliders (371), the scroll bar module (34) comprises two scroll bars (341), and the touchscreen module (33, 33A) comprises a 1.3 inch touchscreen, a 4.3 inch touchscreen, or a 8.5 inch touchscreen, or any combination of the foregoing.

9. The modular control device (10, 10A, 10B) of claim 7 or 8, wherein the plurality of electronic modules (30B) further comprise at least one third electronic module, at least one fourth electronic module, and at least one other fifth electronic module, and wherein the at least one third electronic module is a slider module (37) configured for adjusting playback volume, the at least one fourth electronic module is a scroll bar module (34) configured for content scrolling, and the at least one other fifth electronic module is a touchscreen module (33A) configured for screen display and device input.

10. The modular control device (10, 10A, 10B) of claim 7 or 8, wherein the plurality of electronic modules (30A) further comprises at least one first electronic module, at least one other first electronic module, at least one second electronic module, and at least one fifth electronic module, and wherein the at least one first electronic module and the at least one other first electronic module are button modules (36, 36A) for generating physical or virtual inputs, the at least one second electronic module is a rotary knob module (35) for adjusting parameters, and the at least one fifth electronic module is a touchscreen module (33) configured for screen display and device input.

11. The modular control device (10, 10A, 10B) of claim 7 or 8, wherein the plurality of electronic modules (30) further comprise at least one first electronic module, at least one second electronic module, at least one other second electronic module, and at least one fifth electronic module, wherein the at least one first electronic module is a button module (36) for generating physical or virtual inputs, the at least one second electronic module and the at least one other second electronic module are rotary knob modules (35, 35A) for adjusting parameters, and the at least one fifth electronic module is a touchscreen module (33) configured for screen display and device input.

12. The modular control device (10, 10A, 10B) of one of claims 1 to 11, wherein the module interface comprises a module connector (31) and a module port (21), the module connector (31) defined by one module member and the module port (21) defined by one corresponding base member, the module connector (31) mounted within and electrically coupled to the module port (21), and the retention interface comprises a fastener slot (32) and a fastener prong (22), the fastener slot (32) defined by one other module member and the fastener prong (22) defined by one other corresponding base member, the fastener prong (22) mounted within the fastener slot (32).

13. The modular control device (10, 10A, 10B) of one of claims 1 to 12, wherein the mounting surface (201) comprises a width (W2) and a length (L2) and the base member comprises a plurality of base members, the plurality of base members disposed in at least two or more columns (219) parallel to the length and at least two or more rows (211) parallel to the width.

14. The modular control device (10, 10A, 10B) of one of claims 1 to 13, wherein the plurality of base members comprise a plurality of width edge base members (21W), a plurality of length edge base members (21L), and a plurality of internal base members, the plurality of width edge base members (21W) disposed parallel to one width perimeter (WP) of the mounting surface (201), the plurality of length edge base members (21L) disposed parallel to one length perimeter (LP) of the mounting surface (201), the plurality of internal base members disposed between the plurality of width edge base members (21W) and an opposite width perimeter of the one width perimeter (WP) of the mounting surface (201) and between the plurality of length edge base members (21L) and an opposite length perimeter of the mounting surface (201).

15. The modular control device (10, 10A, 10B) of claim 14, wherein each plurality of width edge base members (21W) and each plurality of length edge base members (21L) comprise the module port (21).

16. The modular control device (10, 10A, 10B) of claim 14 or 15, wherein a distance between each plurality of width edge base members (21W) is the same and a distance between each plurality of length edge base members (21L) is the same.

17. The modular control device (10, 10A, 10B) of one of claims 14 to 16, wherein the plurality of width edge base members (21W) comprise four width edge base members (21W), the plurality of length edge base members (21L) comprise six length edge base members (21L), and the plurality of internal base members comprise eighteen internal base members.

18. The modular control device (10, 10A, 10B) of claim 17, wherein the eighteen internal base members comprise six module ports (21) and twelve fastener prongs (22).

19. The modular control device (10, 10A, 10B) of one of claims 1 to 18, wherein the module interface comprises a universal serial bus interface.
